(19) Europäisches Patentamt
European Patent Office
Office européen des brevets

(11) EP 4 006 620 A1

(12) EUROPEAN PATENT APPLICATION
published in accordance with Art. 153(4) EPC

(43) Date of publication:
01.06.2022 Bulletin 2022/22

(21) Application number: 20848661.3

(22) Date of filing: 28.07.2020

(51) International Patent Classification (IPC):
G02B 26/08 (2006.01)   G02F 1/167 (2019.01)
G02F 1/1675 (2019.01)   G02F 1/1335 (2006.01)
H01L 51/52 (2006.01)

(52) Cooperative Patent Classification (CPC):
G02B 26/08; G02F 1/1335; G02F 1/167;
G02F 1/1675; H01L 51/52

(86) International application number:
PCT/KR2020/009903

(87) International publication number:
WO 2021/020854 (04.02.2021 Gazette 2021/05)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 30.07.2019 KR 20190092470

(71) Applicant: LG Innotek Co., Ltd.
Seoul 07796 (KR)

(72) Inventors:
• KO, Sang Jun
Seoul 07796 (KR)
• LEE, Kweon Jin
Seoul 07796 (KR)
• CHO, Hyun Dong
Seoul 07796 (KR)

(74) Representative: DREISS Patentanwälte PartG
mbB
Friedrichstraße 6
70174 Stuttgart (DE)

(54) **LIGHT ROUTE CONTROL MEMBER AND DISPLAY DEVICE COMPRISING SAME**

(57) A light route control member according to an embodiment comprises: a first substrate into which light is incident from an external area; a first electrode disposed on the top surface of the first substrate; a second substrate disposed above the first substrate; a second electrode disposed on the bottom surface of the second substrate; and a light conversion unit disposed between the second electrode and the second electrode, wherein the light conversion unit comprises partition wall units and receiving units which are alternately arranged, each of the receiving units has a light transmittance that changes according to the application of voltage, the refractive index of the partition wall units is larger than the refractive index of the external areas, and the difference between the refractive index of the partition wall units and the refractive index of the external areas is 0.3 or higher.

[Fig. 9]

**Description**

[Technical Field]

An embodiment relates to a light route control member capable of improving improved front brightness and capable of switching, and to a display device including the same.

[Background Art]

A light-shielding film shields transmitting of light from a light source, and is attached to a front surface of a display panel which is a display device used for a mobile phone, a notebook, a tablet PC, a vehicle navigation device, a vehicle touch, etc., so that the light-shielding film adjusts a viewing angle of light according to an incident angle of light to express a clear image quality at a viewing angle needed by a user when the display transmits a screen.

In addition, the light-shielding film may be used for the window of a vehicle, building or the like to shield outside light partially to prevent glare, or to prevent the inside from being visible from the outside.

That is, the light-shielding film may control the movement path of light, block light in a specific direction, and transmit light in a specific direction.

Meanwhile, such a light-shielding film may be applied to a display device such as a navigation device or a vehicle dashboard in a movement means such as a vehicle. That is, the light-shielding film may be applied to various fields in accordance with various purposes.

In addition, the light-shielding film may be used in various environments of the user. For example, the light-shielding film may be used during the day or night, and may be applied in various environments, such as when the user requires a specific viewing angle or improved visibility.

However, since light transmittance of a light blocking pattern of the light-shielding film is fixed, the user may be restricted in using the light-shielding film in various environments.

Therefore, there is a need for a light route control member having a new structure that may be applied in various use environments.

[Disclosure]

[Technical Problem]

An embodiment is directed to providing a light route control member that is driven in another mode according to application of a voltage and has improved front brightness, and a display device including the same.

[Technical Solution]

A light route control member according to an embodiment includes: a first substrate to which light is incident from an external area; a first electrode disposed on an upper surface of the first substrate; a second substrate disposed above the first substrate; a second electrode disposed on a lower surface of the second substrate; and a light conversion unit disposed between the first electrode and the second electrode, wherein the light conversion unit includes a partition wall unit and a receiving unit alternately disposed, the receiving unit changes light transmittance according to application of a voltage, a refractive index of the partition wall unit is greater than a refractive index of the external area, and a difference between the refractive index of the partition wall unit and the refractive index of the external area is 0.3 or more.

[Advantageous Effects]

A light route control member according to an embodiment can include a light conversion unit in which light transmittance is changed according to application of a voltage.

That is, when a voltage is not applied, the light conversion unit of the light route control member according to the embodiment can be driven as a light blocking part, and when a voltage is applied, the light conversion unit can be driven as a light transmitting part.

Accordingly, the light route control member according to the embodiment can be applied in various ways according to a user's usage environment.

In addition, a width of the light transmitting part can be widened while the light transmitting part of the light route control member according to the embodiment extends from a light incidence part toward a light emitting part. Further, when the voltage is applied, since the light absorbing particles are moved in a direction in which the width is narrowed, the light absorbing particles is easily moved, thereby improving efficiency of the light route control member.

In addition, a decrease in light transmission by the light transmitting part is reduced by disposing the light transmitting part to be spaced apart from an electrode in a direction of a visual field surface or an electrode in a direction opposite to the direction of the visual field surface, so that brightness can be improved, thereby improving visibility of the light route control member.

In addition, in the light route control member according to the embodiment, a refractive index of a partition wall unit can be controlled. In detail, when the light route control member is driven in a first mode, that is, a narrow viewing angle mode by the receiving unit acting for light blocking, the refractive index of the receiving unit can be controlled so that a light transmittance in a lateral direction is decreased.

That is, a scattering angle of light scattered from the partition wall unit can be controlled by controlling the refractive index to a certain range while making the refractive index of the partition wall unit to be greater than the refractive index of the external area.

Accordingly, the transmittance of light emitted in the lateral direction in the first mode is minimized by making the light to pass through the inside of the partition wall unit at a sufficient distance by controlling the scattering angle of the light scattered from the partition wall unit, thereby improving efficiency of the light blocking mode.

[Description of Drawings]

FIG. 1 is a perspective view of a light route control member according to an embodiment.

FIGS. 2 and 3 are views showing a perspective view of a first substrate and a first electrode and a perspective view of a second substrate and a second electrode of the light route control member according to the embodiment, respectively.

FIGS. 4 to 7 are views showing various cross-sectional views of the light route control member according to the embodiment.

FIGS. 8 and 9 are views showing a route of light when the light route control member according to the embodiment is driven in a first mode.

FIGS. 10 to 17 are views for describing a method of manufacturing a light route control member according to an embodiment.

FIG. 18 is a cross-sectional view of a display device to which a light route control member according to an embodiment is applied.

FIGS. 19 and 20 are views for describing one embodiment of the display device to which the light route control member according to the embodiment is applied.

[Modes of the Invention]

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and replaced.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a light route control member according to an embodiment will be described with reference to drawings. The light route control member described below relates to a switchable light route control member that drives in various modes according to application of a voltage.

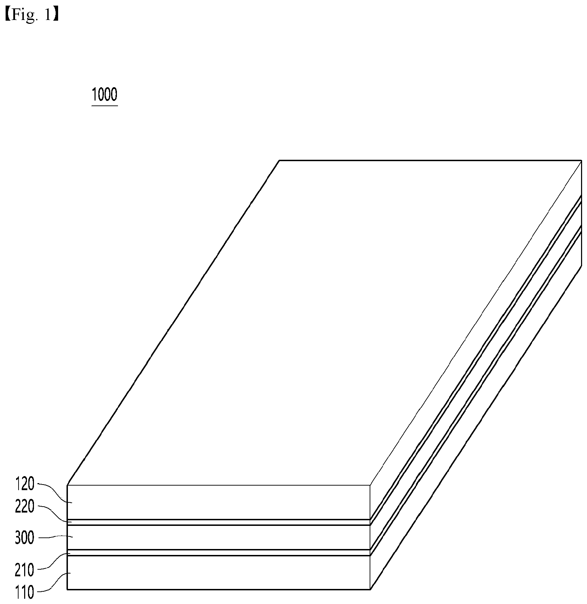

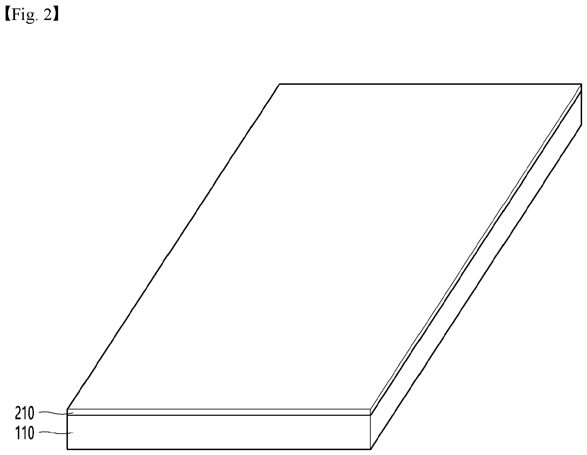

Referring to FIGS. 1 to 3, a light route control member according to an embodiment may include a first substrate 110, a second substrate 120, a first electrode 210, a second electrode 220, and a light conversion unit 300.

The first substrate 110 may support the first electrode 210. The first substrate 110 may be rigid or flexible.

In addition, the first substrate 110 may be transparent. For example, the first substrate 110 may include a transparent substrate capable of transmitting light.

The first substrate 110 may include glass, plastic, or a flexible polymer film. For example, the flexible polymer film may be made of any one of polyethylene terephthalate (PET), polycarbonate (PC), acrylonitrile-butadiene-styrene copolymer (ABS), polymethyl methacrylate (PMMA), polyethylene naphthalate (PEN), polyether sulfone (PES), cyclic olefin copolymer (COC), triacetylcellulose (TAC) film, polyvinyl alcohol (PVA) film, polyimide (PI) film, and polystyrene (PS), which is only an example, but the embodiment is not limited thereto.

In addition, the first substrate 110 may be a flexible substrate having flexible characteristics.

Further, the first substrate 110 may be a curved or bended substrate. That is, the light route control member including the first substrate 110 may also be formed to have flexible, curved, or bent characteristics. Accordingly, the light route control member according to the embodiment may be changed to various designs.

The first substrate 110 may have a thickness of about 1mm or less.

The first electrode 210 may be disposed on one surface of the first substrate 110. In detail, the first electrode 210 may be disposed on an upper surface of the first substrate 110. That is, the first electrode 210 may be disposed between the first substrate 110 and the second substrate 120.

The first electrode 210 may contain a transparent conductive material. For example, the first electrode 210 may contain a metal oxide such as indium tin oxide, indium zinc oxide, copper oxide, tin oxide, zinc oxide, titanium oxide, etc.

The first electrode 210 may be disposed on the first substrate 110 in a film shape. In detail, light transmittance of the first electrode 210 may be about 80% or more.

The first electrode 210 may have a thickness of about 10nm to about 50nm.

Alternatively, the first electrode 210 may contain various metals to realize low resistance. For example, the first electrode 210 may contain at least one metal of chromium (Cr), nickel (Ni), copper (Cu), aluminum (Al), silver (Ag), molybdenum (Mo). gold (Au), titanium (Ti), and alloys thereof.

Alternatively, the first electrode 210 may include a plurality of conductive patterns. For example, the first electrode 210 may include a plurality of mesh lines intersecting each other and a plurality of mesh openings formed by the mesh lines.

Accordingly, even though the first electrode 210 contains a metal, visibility may be improved because the first electrode is not visible from the outside. In addition, the light transmittance is increased by the openings, so that the brightness of the light route control member according to the embodiment may be improved.

The second substrate 120 may be disposed on the first substrate 110. In detail, the second substrate 120 may be disposed on the first electrode 210 on the first substrate 110.

The second substrate 120 may contain a material capable of transmitting light. The second substrate 120 may contain a transparent material. The second substrate 120 may contain a material the same as or similar to that of the first substrate 110 described above.

For example, the second substrate 120 may include glass, plastic, or a flexible polymer film. For example, the flexible polymer film may be made of any one of polyethylene terephthalate (PET), polycarbonate (PC), acrylonitrile-butadiene-styrene copolymer (ABS), polymethyl methacrylate (PMMA), polyethylene naphthalate (PEN), polyether sulfone (PES), cyclic olefin copolymer (COC), triacetylcellulose (TAC) film, polyvinyl alcohol (PVA) film, polyimide (PI) film, and polystyrene (PS), which is only an example, but the embodiment is not limited thereto.

In addition, the second substrate 120 may be a flexible substrate having flexible characteristics.

Further, the second substrate 120 may be a curved or bended substrate. That is, the light route control member including the second substrate 120 may also be formed to have flexible, curved, or bent characteristics. Accordingly, the light route control member according to the embodiment may be changed to various designs.

The second substrate 120 may have a thickness of about 1mm or less.

The second electrode 220 may be disposed on one surface of the second substrate 120. In detail, the second electrode 220 may be disposed on a lower surface of the second substrate 120. That is, the second electrode 220 may be disposed on a surface on which the second substrate 120 faces the first substrate 110. That is, the second electrode 220 may be disposed facing the first electrode 210 on the first substrate 110. That is, the second electrode 220 may be disposed between the first electrode 210 and the second substrate 120.

The second electrode 220 may contain a transparent conductive material. For example, the second electrode 220 may contain a metal oxide such as indium tin oxide, indium zinc oxide, copper oxide, tin oxide, zinc oxide, titanium oxide, etc.

The second electrode 220 may be disposed on the first substrate 110 in a film shape. In addition, the light transmittance of the second electrode 220 may be about 80% or more.

The second electrode 220 may have a thickness of about 10nm to about 50nm.

Alternatively, the second electrode 220 may contain various metals to realize low resistance. For example, the second electrode 220 may contain at least one metal of chromium (Cr), nickel (Ni), copper (Cu), aluminum (Al), silver (Ag), molybdenum (Mo). gold (Au), titanium (Ti), and alloys thereof.

Alternatively, the second electrode 220 may include a plurality of conductive patterns. For example, the second electrode 220 may include a plurality of mesh lines intersecting each other and a plurality of mesh openings formed by the mesh lines.

Accordingly, even though the second electrode 220 contains a metal, visibility may be improved because the second electrode 220 is not visible from the outside. In addition, the light transmittance is increased by the openings, so that the brightness of the light route control member according to the embodiment may be improved.

The light conversion unit 300 may be disposed between the first substrate 110 and the second substrate 120. In detail, the light conversion unit 300 may be disposed between the first electrode 210 and the second electrode 220.

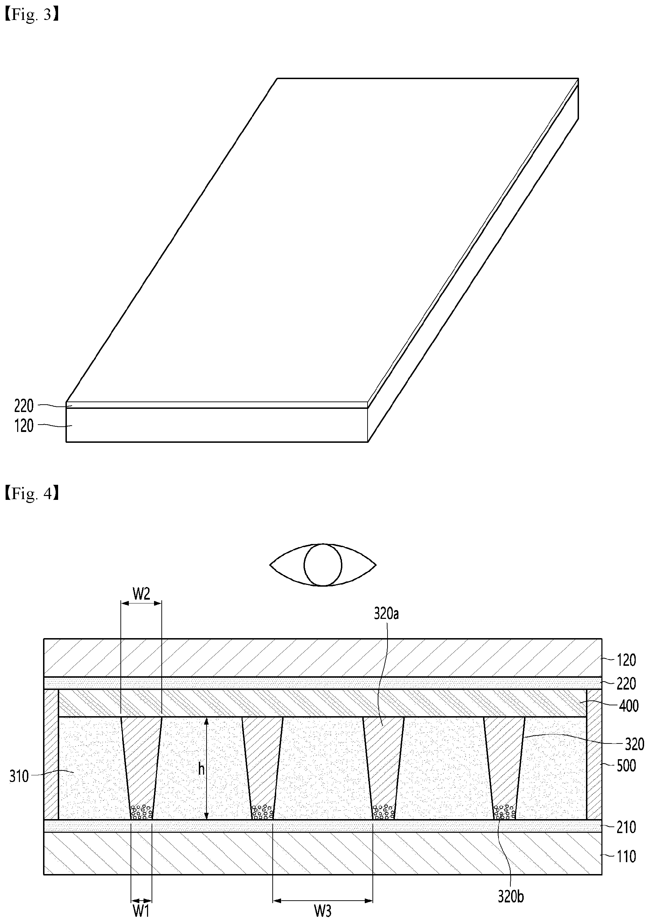

Referring to FIGS. 4 to 7, the light conversion unit 300 may include a partition wall unit 310 and a receiving unit 320.

The partition wall unit 310 may be defined as a partition wall region for partitioning a region of the light conversion unit, and the receiving unit 320 may be defined as a variable region that is variable to a light blocking unit and a light transmitting unit according to application of voltage.

The partition wall unit 310 and the receiving unit 320 may be alternately disposed. The partition wall unit 310 and the receiving unit 320 may be disposed in different widths. For example, the width of the receiving unit 320 may be greater than the width of the receiving unit 320.

The partition wall unit 310 and the receiving unit 320 may be disposed in direct or indirect contact with at least one of the first electrode 210 and the second electrode 220.

For example, the partition wall unit 310 and the receiving unit 320 may be disposed in direct contact with the first electrode 210 and may be disposed in indirect contact with the second electrode 220. That is, an adhesive layer 400 for adhering the first substrate 110 and the second substrate 120 may be disposed on the light conversion part 300, and the partition wall unit 310 and the receiving unit 320 may be disposed in indirect contact with the second electrode 220.

Alternatively, although not shown in the drawings, a buffer layer for improving adhesion between the light conversion unit and the first electrode 210 may be disposed between the light conversion unit and the first electrode 210, and the receiving unit 310 and the first electrode 210 may be disposed to be spaced apart from each other.

The partition wall unit 310 and the receiving unit 320 may be alternately disposed. In detail, the partition wall unit 310 and the receiving unit 320 may be alternately disposed. That is, each of the partition wall units 310 may be disposed between the receiving units 320 adjacent to each other, and each of the receiving units 320 may be disposed between the partition wall units 310 adjacent to each other.

The partition wall unit 310 may contain a transparent material. The partition wall unit 310 may contain a material that may transmit light.

The partition wall unit 310 may contain a resin material. For example, the partition wall unit 310 may contain a photo-curable resin material. As an example, the partition wall unit 310 may contain a UV resin or a transparent photoresist resin. Alternatively, the partition wall unit 310 may contain urethane resin or acrylic resin.

The partition wall unit 310 may transmit light incident on any one of the first substrate 110 and the second substrate 120 toward another substrate.

For example, in FIGS. 4 to 7, light may be emitted in a direction of the first substrate 110 and the light may be incident on the first substrate 110. The partition wall unit 310 may transmit the light, and the transmitted light may be moved in a direction of the second substrate 120.

The partition wall unit 310 may have a certain refractive index. In detail, the partition wall unit 310 may be controlled to have a refractive index within a specific range in order to improve the light blocking effect. To this end, the partition wall unit 310 may further include an additive for controlling the refractive index.

The refractive index of the partition wall unit 310 will be described in detail below.

The receiving unit 320 may include a light conversion material including an electrolyte 320a and light absorbing particles 320b. In detail, the receiving unit 320 is filled with the electrolyte 320a, and a plurality of the light absorbing particles 320b may be dispersed in the electrolyte 320a.

The electrolyte 320a may be a material for dispersing the light absorbing particles 320b. The electrolyte 320a may contain a transparent material. The electrolyte 320a may contain a paraffinic solvent. In addition, the electrolyte 320a may contain a material capable of transmitting light.

The light absorbing particles 320b may be disposed to be dispersed in the electrolyte 320a. In detail, the plurality of light absorbing particles 320b may be disposed to be spaced apart from each other in the electrolyte 320a.

The light absorbing particles 320b may have a color. For example, the light absorbing particles 320b may have black light absorbing particles. As an example, the light absorbing particles 320b may include carbon black. That is, the light absorbing particles 320b may be carbon black particles.

The light absorbing particles 320b may be formed in a spherical shape or a circular shape. The light absorbing particles 320b may have a diameter of several nanometers.

The light transmittance of the receiving unit 320 may be changed by the light absorbing particles 320b. In detail, the receiving unit 320 may be changed into the light blocking part and the light transmitting part by changing the light transmittance due to the movement of the light absorbing particles 320b.

For example, the light route control member according to the embodiment may be changed from a first mode to a second mode or from the second mode to the first mode by a voltage applied to the first electrode 210 and the second electrode 220.

In detail, in the light route control member according to the embodiment, the receiving unit 320 becomes the light blocking part in the first mode, and light of a specific angle may be blocked by the receiving unit 320. That is, a viewing angle of the user viewing from the outside may be narrowed.

In addition, in the light route control member according to the embodiment, the receiving unit 320 becomes the light transmitting part in the second mode, and in the light route control member according to the embodiment, light may be transmitted through both the partition wall unit 310 and the receiving unit 320. That is, the viewing angle of the user viewing from the outside may be widened.

Switching from the first mode to the second mode, that is, the conversion of the receiving unit 320 from the light blocking part to the light transmitting part may be realized by movement of the light absorbing particles 320b of the receiving unit 320.

In detail, the receiving unit 320 may be electrically connected to the first electrode 210 and the second electrode 220.

In this case, when a voltage is not applied to the light route control member from the outside, the light absorbing particles 320b of the receiving unit 320 are uniformly dispersed in the electrolyte 320a, and light may be blocked by the light absorbing particles in the receiving unit 320. Accordingly, in the first mode, the receiving unit 320 may be driven as the light blocking part.

Alternatively, when a voltage is applied to the light route control member from the outside, the light absorbing particles 320b may move. For example, the light absorbing particles 320b may move toward one end or the other end of the receiving unit 320 by a voltage transmitted through the first electrode 210 and the second electrode 220. That is, the light absorbing particles 320b may move from the receiving unit 320 toward the first electrode or the second electrode.

As a method of moving the light absorbing particles, first, the light absorbing particles including the carbon black may be charged. For example, micelles may be formed and a charging effect may be created by charging the carbon black light absorbing particles themselves with a negative charge or chemically introducing a functional group similar to a surfactant to a surface of the carbon black light absorbing particles to charge the light absorbing particles.

Subsequently, when a voltage is applied to the first electrode 210 and/or the second electrode 220, an electric field is formed between the first electrode 210 and the second electrode 220, and the charged carbon black, that is, the light absorbing particles may be moved toward a positive electrode of the first electrode 210 and the second electrode 220 using the electrolyte 320a as a medium.

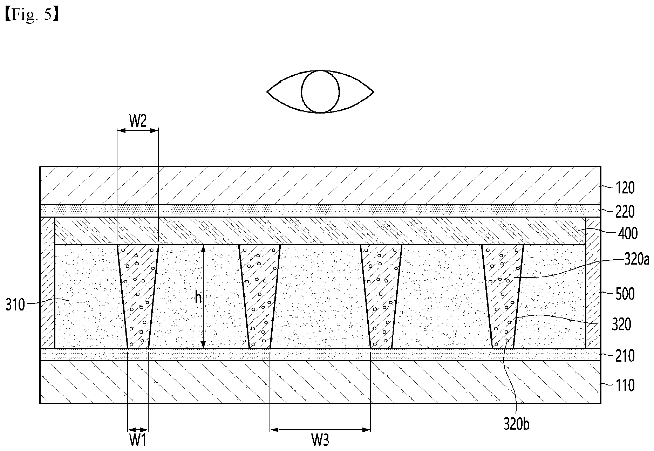

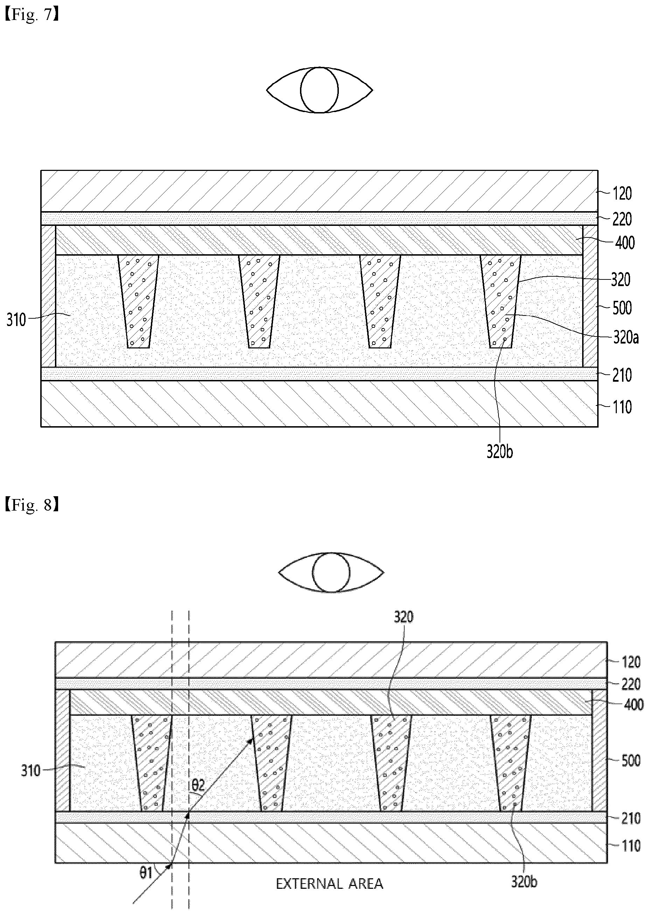

That is, when the voltage is not applied to the first electrode 210 and/or the second electrode 220, as shown in FIGS. 5 and 7, the light absorbing particles 320b may be uniformly dispersed in the electrolyte 320a to drive the receiving unit 320 as the light blocking part.

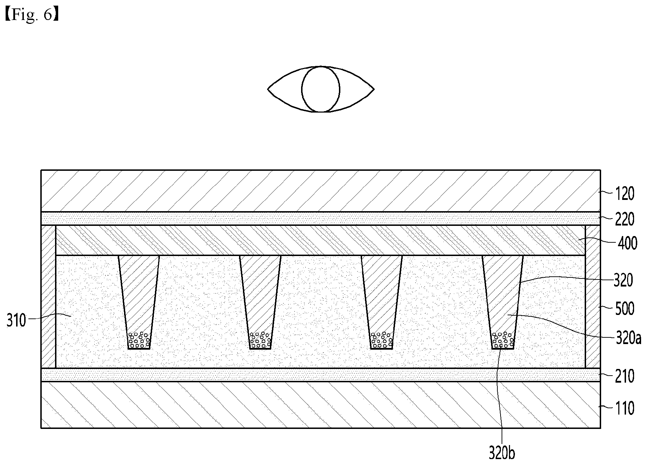

In addition, when the voltage is applied to the first electrode 210 and/or the second electrode 220, as shown in FIGS. 4 and 6, the light absorbing particles 320b may be moved toward the second electrode 220 in the electrolyte 320a. That is, the light absorbing particles 320b are moved in one direction, and the receiving unit 320 may be driven as the light transmitting part.

Accordingly, the light route control member according to the embodiment may be driven in two modes according to a user's surrounding environment. That is, when the user requires light transmission only at a specific viewing angle, the receiving unit is driven as the light blocking part, or in an environment in which the user requires high brightness, a voltage may be applied to drive the receiving unit as the light transmitting part.

Therefore, since the light route control member according to the embodiment may be implemented in two modes according to the user's requirement, the light route control member may be applied regardless of the user's environment.

Meanwhile, the receiving unit 320 may be formed in various shapes.

Alternatively, referring to FIGS. 4 and 5, a width of the receiving unit 320 may be changed while the receiving unit 320 extends from one end of the receiving unit 320 to the other end thereof.

For example, referring to FIGS. 4 and 5, the receiving unit 320 may be formed in a trapezoidal shape. In detail, the receiving unit 320 may be formed so that the width of the receiving unit 320 is widened while extending from the first electrode 210 toward the second electrode 220.

That is, the width of the receiving unit 320 may be narrower while the receiving unit 320 extends from a visual field surface of the user toward an opposite surface thereof. In addition, when a voltage is applied to the light conversion unit, the light absorbing particles of the receiving unit 320 may be moved in a direction in which the width of the receiving unit is narrowed.

That is, the width of the of the receiving unit 320 may be widened while the receiving unit 320 extends from a light incident part in which light is incident toward a light emitting part in which light is emitted.

That is, the light absorbing particles of the receiving unit 320 may be moved toward the first electrode 210.

Accordingly, since the light absorbing particles are moved toward the opposite surface of the visual field surface instead of the visual field surface, it is possible to prevent blocking of light emitted toward the visual field surface, thereby improving the brightness of the light route control member.

In addition, since the light absorbing particles are moved from a wide region toward a narrow region, the light absorbing particles may be easily moved.

In addition, since the light absorbing particles move to the narrow region of the receiving unit, an amount of light transmitted toward the visual field surface of the user is increased, thereby improving front brightness.

Or, conversely, the receiving unit 320 may be formed so that the width of the receiving unit 320 is narrowed while extending from the first electrode 210 toward the second electrode 220.

That is, the width of the receiving unit 320 may be widened while the receiving unit 320 extends from the visual field surface of the user toward the opposite surface thereof. In addition, when a voltage is applied to the light transmitting part, the light absorbing particles of the receiving unit 320 may be moved in a direction in which the width of the receiving unit is widened.

That is, the width of the of the receiving unit 320 may be narrowed while the receiving unit 320 extends from the light incident part in which the light is incident toward the light emitting part in which the light is emitted.

That is, the light absorbing particles of the of the receiving unit 320 may be moved toward the first electrode 210.

Accordingly, a contact region between the first electrode and one surface of the receiving unit through which the light absorbing particles move is increased, so that a moving speed of the light absorbing particles, that is, a driving speed may be increased.

Meanwhile, the receiving unit 320 may be disposed to be spaced apart from the first electrode 210 or the second electrode 220. That is, the receiving unit 320 may be disposed in contact with only one of the first electrode 210 and the second electrode 220.

For example, referring to FIGS. 6 and 7, the receiving unit 320 may be spaced apart from the first electrode 210 and may be in contact with the receiving unit 320. That is, the receiving unit 320 may be in indirect contact with the second electrode 220 via the adhesive layer 400.

A material which is the same as or similar to that of the partition wall unit 310 may be disposed in a region where the receiving unit 320 and the first electrode 210 are spaced apart from each other.

Accordingly, the brightness of the light route control member may be improved by increasing the transmittance of the light emitted in the direction of the viewing surface, thereby improving visibility.

As described above, in the light route control member according to the embodiment, the refractive index of the partition wall unit 310 may be controlled in order to increase the light blocking effect. In detail, when the light route control member is driven in the first mode, the refractive index of the partition wall unit 310 may be controlled to narrow the viewing angle in the left and right directions.

FIG. 8 is a view showing a route of light when the light route control member according to the embodiment is driven in a first mode, that is, when the receiving unit serves as a light blocking portion.

Referring to FIG. 8, light incident on the light route control member from an external area may be incident at a first angle $\theta_1$. The light incident at the first angle $\theta_1$ may be defined as an incident angle. In addition, the light incident on the light route control member and incident on the partition wall unit 310 may be incident at a second angle $\theta_2$. The second angle $\theta_2$ may be defined as a scattering angle.

Referring to FIG. 8, light emitted in a direction of the second substrate may be changed depending on a size of a scattering angle of light incident in a direction of the partition wall unit 310. In detail, it can be seen that as the scattering angle of the light incident on the inside of the partition wall unit 310 becomes smaller, an amount of transmitted light is increased than that of light blocked, so that the light blocking effect is reduced.

That is, when the scattering angle of light incident on the inside of the partition wall unit 310 becomes small, the light incident on the inside of the partition wall unit 310 does not pass through the receiving unit 320 at all or a distance passing through the receiving unit 320 is decreased, the light blocking effect in a side surface of the light route control member may be reduced.

The scattering angle of the light incident on the partition wall unit 310 is related to the refractive index of the partition wall unit 310, and accordingly, in light route control member according to the embodiment, the refractive index of the partition wall unit 310 may be controlled within a specific range in order to control the scattering angle of the light incident on the partition wall unit 310.

In detail, according to Snell's law, the scattering angle of the partition wall unit may be changed by a difference between a refractive index of the outside and the refractive index of the partition wall unit 310 when the light incident on the partition wall unit 310 of the light route control member from the outside.

In detail, as the scattering angle becomes smaller, a transmittance of light transmitted upward of the partition wall unit 310 may be increased, and as the scattering angle becomes larger, a transmittance of light transmitted upward of the receiving unit 310 may be decreased.

In this case, in the first mode, that is, in the light blocking mode, when the light transmittance exceeds about 1%, the viewing angle of the user is increased, so that the light blocking effect may be reduced.

Therefore, in the light route control member according to the embodiment, the scattering angle inside the partition wall unit 310 may be controlled so that the light transmittance is about 1% or less in the first mode. That is, in the light route control member according to the embodiment, the refractive index of the partition wall unit 310 may be controlled so that the light transmittance is about 1% or less in the first mode.

In detail, when a refractive index of an external area A in which light is incident in a direction of the light route control member is defined as a first refractive index, and the refractive index of the partition wall unit 310 of the light route control member is defined as a second refractive index, the second refractive index may be greater than the first refractive index, and a difference between the second refractive index and the first refractive index may be 0.3 or more. In detail, the difference between the second refractive index and the first refractive index may be 0.4 or more. In more detail, the difference between the second refractive index and the first refractive index may be 0.45 or more.

As an example, the difference between the second refractive index and the first refractive index may be 0.3 to 0.9. In detail, the difference between the second refractive index and the first refractive index may be 0.4 to 0.8. In more detail, the difference between the second refractive index and the first refractive index may be 0.45 to 0.5.

For example, when the external area is defined as air having a refractive index value of 1, the refractive index of the partition wall unit 310 may be 1.3 or more. In detail, the refractive index of the partition wall unit may be 1.4 or more. In more detail, the refractive index of the partition wall unit may be 1.45 or more. In more detail, the refractive index of the partition wall unit may be 1.5 or more.

When the difference between the second refractive index and the first refractive index is less than about 0.3, the distance of light passing through the receiving unit is decreased, and thus, the light transmittance is increased, so that the light blocking effect may be reduced. In addition, when the difference between the second refractive index and the first refractive index exceeds about 0.9, the distance of light passing through the receiving unit is decreased, or the light does not pass through the receiving unit, and thus the light transmittance is increased, so that the light blocking effect may be reduced.

That is, in the light route control member according to the embodiment, the following equation may be satisfied by controlling the refractive index of the receiving unit.

[Equation]

Width of receiving unit*0.9 < Distance of light passing through receiving unit <

Width of receiving unit*1.7

Hereinafter, the present invention will be described in more detail through the light transmittance of the light route control member according to Examples and Comparative examples. Such Examples are merely illustrated to describe the present invention in more detail. Therefore, the present invention is not limited to such Examples.

Example

Light incident from an air area having the refractive index of 1 was incident on the inside of the partition wall unit through the first substrate and the first electrode.

At this time, the second refractive index of the partition wall unit was greater than the first refractive index of the air area, and while changing the second refractive index of the partition wall unit from 1.3 to 1.9, the scattering angle inside the partition wall unit, a distance D at which the incident light passes through the receiving unit including the black light absorbing particles and acting for light blocking, and an optical density and a light transmittance were measured.

At this time, a maximum width of the partition wall unit and the receiving unit was set to 30μm, and a maximum height of the partition wall unit and the receiving unit was set to 100μm.

Comparative Example

Similar to Example, the scattering angle inside the partition wall unit, the distance D at which the incident light passes through the receiving unit including the black light absorbing particles and acting for light blocking, and the optical density and the light transmittance were measured, except that the second refractive index of the partition wall unit was greater than the first refractive index of the air area and the second refractive index of the partition wall unit was changed from 2.0 to 2.6.

[Table 1]

| Air area | | Partition wall unit area | | Optical properties | | |
|---|---|---|---|---|---|---|
| First refractive index | Incident angle (θ1) | Second refractive index | Scattering angle (θ2) | D (μm) | Optical density | Light transmittance (%) |
| 1 | 45° | 1.3 | 26.48° | 39.88 | 3.97 | 0.011 |
| 1 | 45° | 1.4 | 27.98° | 44.30 | 4.38 | 0.009 |
| 1 | 45° | 1.45 | 28.15° | 49.03 | 4.24 | 0.002 |
| 1 | 45° | 1.5 | 28.13° | 49.75 | 4.48 | 0.003 |
| 1 | 45° | 1.6 | 26.23° | 43.60 | 3.92 | 0.012 |
| 1 | 45° | 1.7 | 24.58° | 37.84 | 3.41 | 0.039 |
| 1 | 45° | 1.8 | 23.13° | 32.37 | 2.91 | 0.122 |
| 1 | 45° | 1.9 | 21.85° | 27.13 | 2.44 | 0.362 |
| 1 | 45° | 2.0 | 20.70° | 22.05 | 1.98 | 1.036 |
| 1 | 45° | 2.1 | 19.68° | 17.11 | 1.54 | 2.887 |
| 1 | 45° | 2.2 | 18.75° | 12.27 | 1.10 | 7.873 |
| 1 | 45° | 2.3 | 17.90° | 7.51 | 0.68 | 21.096 |
| 1 | 45° | 2.4 | 17.14° | 2.82 | 0.25 | 55.726 |
| 1 | 45° | 2.5 | 16.43° | - | - | - |
| 1 | 45° | 2.6 | 15.78° | - | - | - |

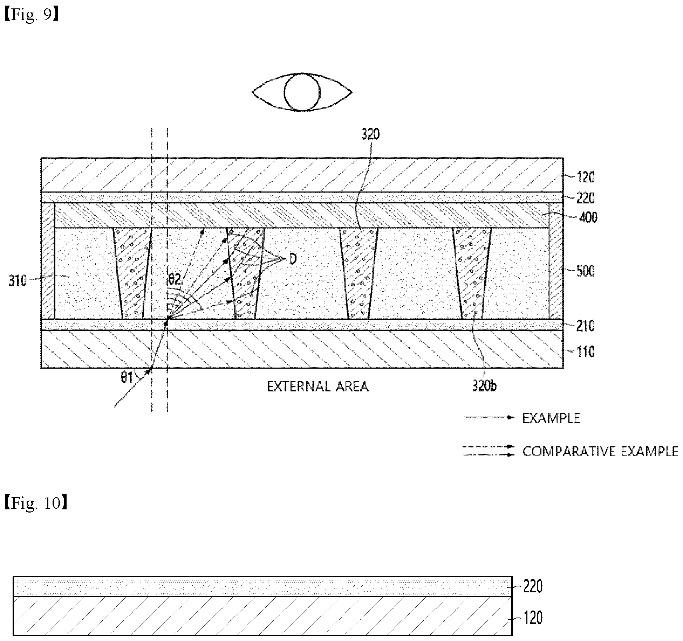

Referring to Table 1 and FIG. 9, it can be seen that the light route control member according to Example has a distance through which the light incident on the inside of the partition wall unit passes through the partition wall unit longer than that of the light route control member according to Comparative Example.
That is, when the refractive index of the partition wall unit is 1.3 to 1.9, that is, the difference in refractive index between the external area and the partition wall unit is 0.3 to 0.9, a route in which the light incident on the partition wall unit passes through the receiving unit is increased, so that the light transmittance may be reduced.
On the other hand, it can be seen that the light route control member according to Comparative Example has a distance through which the light incident on the inside of the partition wall unit passes through the partition wall unit shorter than that of the light route control member according to Example.
In detail, when the refractive index of the partition wall unit is less than 1.3, that is, the difference in refractive index between the external area and the partition wall unit is less than 0.3, the route in which the light incident on the partition wall unit passes through the receiving unit is decreased, so that it can be seen that a transmittance of light transmitted toward the user is increased.
In addition, when the refractive index of the partition wall unit exceeds 1.9, that is, the difference in refractive index between the external area and the partition wall unit exceeds 0.9, the route in which the light incident on the partition wall unit passes through the receiving unit is decreased, or the light does not pass through the partition wall unit, so that it can be seen that the transmittance of light transmitted toward the user is increased.
A light route control member according to an embodiment may include a light conversion unit in which light transmittance is changed according to application of a voltage.
That is, when a voltage is not applied, the light conversion unit of the light route control member according to the embodiment may be driven as a light blocking part, and when a voltage is applied, the light conversion unit may be driven as a light transmitting part.

Accordingly, the light route control member according to the embodiment may be applied in various ways according to a user's usage environment.

In addition, a width of the light transmitting part may be widened while the light transmitting part of the light route control member according to the embodiment extends from a light incidence part toward the light emitting part. Further, when the voltage is applied, since the light absorbing particles are moved in a direction in which the width is narrowed, the light absorbing particles is easily moved, thereby improving efficiency of the light route control member.

In addition, a decrease in light transmission by the light transmitting part is reduced by disposing the light transmitting part to be spaced apart from an electrode in a direction of a visual field surface or an electrode in a direction opposite to the direction of the visual field surface, so that brightness may be improved, thereby improving visibility of the light route control member.

In addition, in the light route control member according to the embodiment, a refractive index of a partition wall unit may be controlled. In detail, when the light route control member is driven in a first mode, that is, a narrow viewing angle mode by the receiving unit acting for light blocking, the refractive index of the receiving unit may be controlled so that a light transmittance in a lateral direction is decreased.

That is, a scattering angle of light scattered from the partition wall unit may be controlled by controlling the refractive index to a certain range while making the refractive index of the partition wall unit to be greater than the refractive index of the external area.

Accordingly, the transmittance of light emitted in the lateral direction in the first mode is minimized by making the light to pass through the inside of the partition wall unit at a sufficient distance by controlling the scattering angle of the light scattered from the partition wall unit, thereby improving efficiency of the light blocking mode.

Hereinafter, a method of manufacturing a light route control member according to an embodiment will be described with reference to FIGS. 10 to 17.

First, referring to FIG. 10, an electrode material forming a first substrate 110 and a first electrode is prepared. Subsequently, the electrode material may be formed on one surface of the first substrate 110 by a coating or deposition process. In detail, the electrode material may be formed on the entire surface of the first substrate 110. Accordingly, a first electrode 210 formed as a surface electrode may be formed on the first substrate 110.

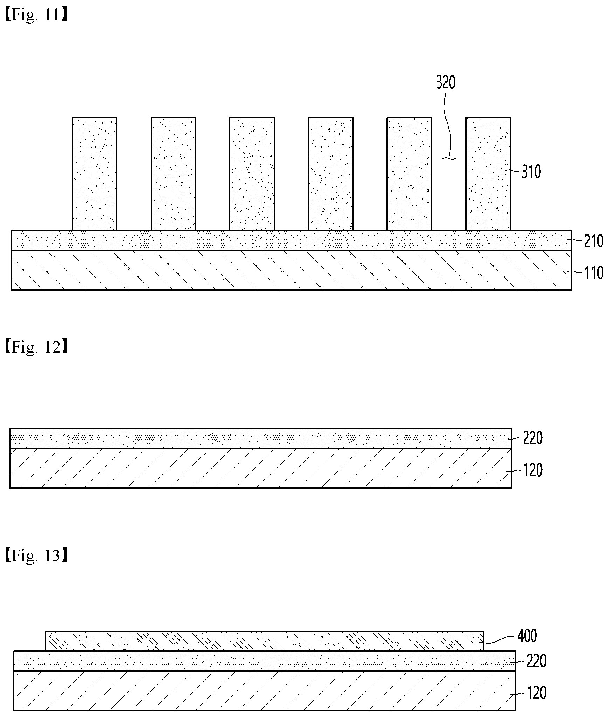

Subsequently, referring to FIG. 11, a resin layer may be formed by applying a resin material on the first electrode 210. In detail, the resin layer may be formed by applying a urethane resin or an acrylic resin on the first electrode 210.

Subsequently, a pattern part may be formed on the resin layer using a mold. In detail, holes or grooves are formed in the resin layer by imprinting the mold, and accordingly, a partition wall unit may be formed by the remaining resin layer. That is, the partition wall unit 310 and the receiving unit 320 described above may be formed on the resin layer.

Subsequently, referring to FIG. 12, an electrode material forming a second substrate 120 and a second electrode is prepared. Subsequently, the electrode material may be formed on one surface of the second substrate 120 by a coating or deposition process. In detail, the electrode material may be formed on the entire surface of the second substrate 120. Accordingly, a second electrode 220 formed as a surface electrode may be formed on the second substrate 120.

Subsequently, referring to FIG. 13, an adhesive layer 400 may be formed by applying an adhesive material on the second electrode 220. The adhesive layer 400 may be formed on a partial region of the second electrode 220.

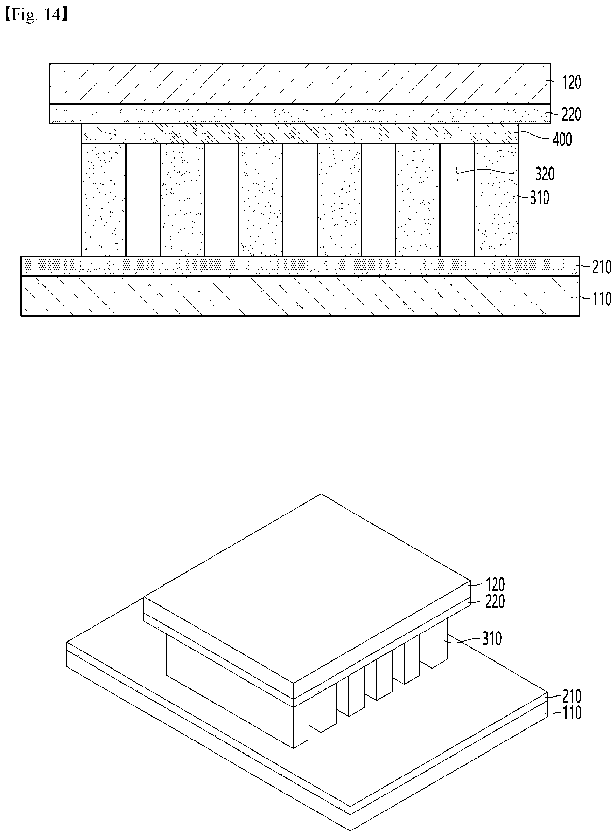

Subsequently, referring to FIG. 14, the first substrate 110 and the second substrate 120 manufactured in advance may be adhered. In detail, the first substrate 110 and the second substrate 120 may be adhered to each other through the adhesive layer 400 on the second substrate 120.

In this case, the first substrate 110 and the second substrate 120 may be adhered in different directions. In detail, the first substrate 110 and the second substrate 120 may be adhered to each other so that a long side direction of the first substrate 110 and a short side direction of the second substrate 120 overlap each other.

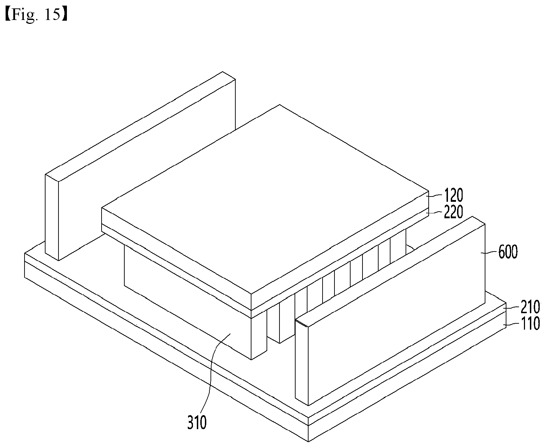

Subsequently, referring to FIG. 15, a dam part 600 may be formed on the first substrate 110. In detail, the dam part 600 may be disposed above and below the receiving unit 320 disposed on the first substrate 110. That is, the dam part 600 may be disposed so that the receiving unit 320 is disposed between the dam part 600.

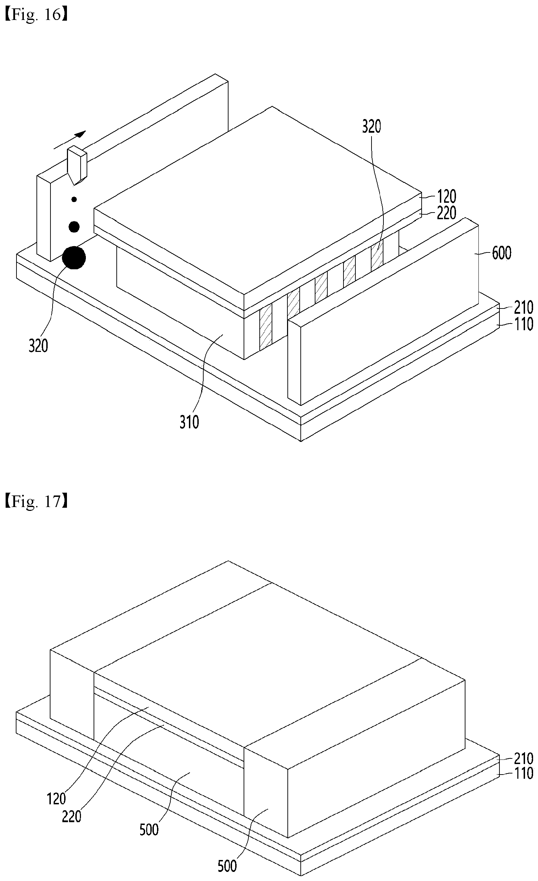

Subsequently, referring to FIG. 16, a light conversion material may be injected between the receiving unit 320, that is, the partition wall units 310. In detail, a light conversion material in which light absorbing particles such as carbon black or the like are dispersed in an electrolyte solvent containing a paraffinic solvent may be injected between the receiving unit 320, that is, between the partition wall units. Accordingly, the partition wall unit 310 described above may be formed between the receiving units 320.

Subsequently, referring to FIG. 17, the light conversion material inside the receiving unit may be sealed from the outside by forming a sealing part 500 in the lateral direction of the receiving unit 320. Subsequently, a final light route control member may be formed by cutting the first substrate 110.

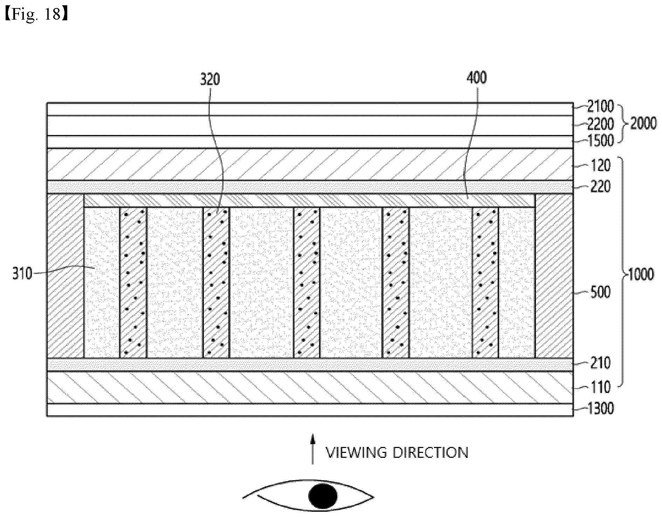

Hereinafter, referring to FIGS. 18 to 20, a display device and a display apparatus to which a light route control member according to an embodiment is applied will be described.

Referring to FIG. 18, a light route control member 1000 according to an embodiment may be disposed on a display panel 2000.

The display panel 2000 and the light route control member 1000 may be disposed to be adhered to each other. For example, the display panel 2000 and the light route control member 1000 may be adhered to each other via an adhesive layer 1500. The adhesive layer 1500 may be transparent. For example, the adhesive layer 1500 may include an adhesive or an adhesive layer containing an optical transparent adhesive material.

The adhesive layer 1500 may include a release film. In detail, when adhering the light route control member and the display panel, the light route control member and the display panel may be adhered after the release film is removed.

The display panel 2000 may include a first substrate 2100 and a second substrate 2200. When the display panel 2000 is a liquid crystal display panel, the display panel 2000 may be formed in a structure in which the first substrate 2100 including a thin film transistor (TFT) and a pixel electrode and the second substrate 2200 including color filter layers are bonded with a liquid crystal layer interposed therebetween.

In addition, the display panel 2000 may be a liquid crystal display panel of a color filter on transistor (COT) structure in which a thin film transistor, a color filter, and a black matrix are formed at the first substrate 2100 and the second substrate 2200 is bonded to the first substrate 2100 with the liquid crystal layer interposed therebetween. That is, a thin film transistor may be formed on the first substrate 2100, a protective film may be formed on the thin film transistor, and a color filter layer may be formed on the protective film. In addition, a pixel electrode in contact with the thin film transistor may be formed on the first substrate 2100. At this point, in order to improve an aperture ratio and simplify a masking process, the black matrix may be omitted, and a common electrode may be formed to function as the black matrix.

In addition, when the display panel 2000 is the liquid crystal display panel, the display device may further include a backlight unit providing light from a rear surface of the display panel 2000.

Alternatively, when the display panel 2000 is an organic light emitting display panel, the display panel 2000 may include a self-luminous element that does not require a separate light source. In the display panel 2000, a thin film transistor may be formed on the first substrate 2100, and an organic light emitting element in contact with the thin film transistor may be formed. The organic light emitting element may include an anode, a cathode, and an organic light emitting layer formed between the anode and the cathode. Further, the second substrate 2200 configured to function as an encapsulation substrate for encapsulation may further be included on the organic light emitting element.

Furthermore, although not shown in drawings, a polarizing plate may be further disposed between the light route control member 1000 and the display panel 2000. The polarizing plate may be a linear polarizing plate or an external light reflection preventive polarizing plate. For example, when the display panel 2000 is a liquid crystal display panel, the polarizing plate may be the linear polarizing plate. Further, when the display panel 2000 is the organic light emitting display panel, the polarizing plate may be the external light reflection preventive polarizing plate.

In addition, an additional functional layer 1300 such as an anti-reflection layer, an anti-glare, or the like may be further disposed on the light route control member 1000. Specifically, the functional layer 1300 may be adhered to one surface of the substrate of the light route control member. Although not shown in drawings, the functional layer 1300 may be adhered to the base 100 of the light route control member via an adhesive layer. In addition, a release film for protecting the functional layer may be further disposed on the functional layer 1300.

Further, a touch panel may be further disposed between the display panel and the light route control member.

Although it is shown in the drawings that the light route control member is disposed at an upper portion of the display panel, but the embodiment is not limited thereto, and the light route control member may be disposed at various positions such as a position in which light is adjustable, that is, a lower portion of the display panel, between a second substrate and a first substrate of the display panel, or the like.

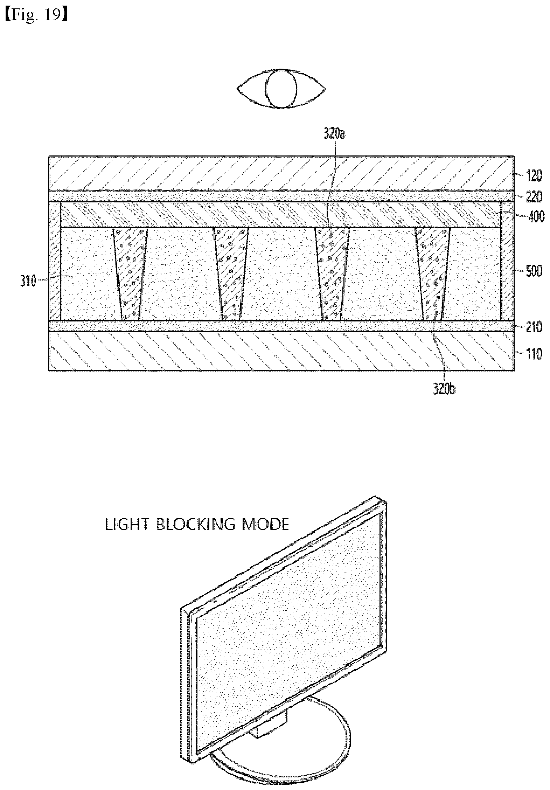

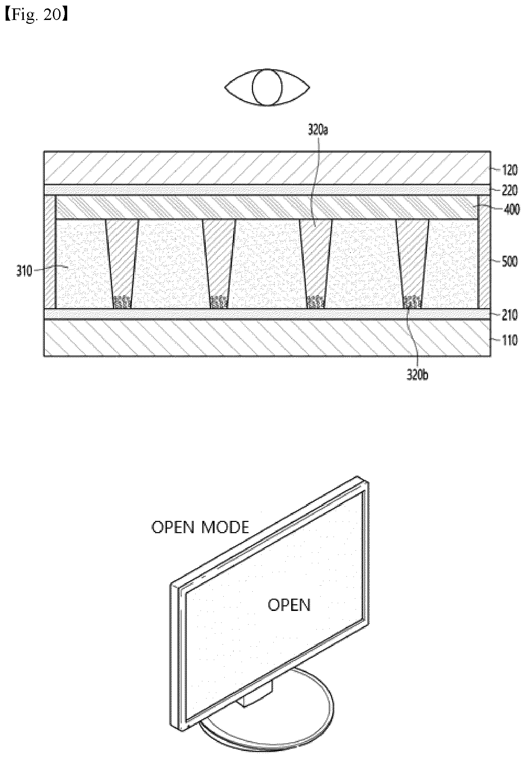

Referring to FIGS. 19 and 20, the light route control member according to the embodiment may be applied to a vehicle.

Referring to FIGS. 19 and 20, the light route control member according to the embodiment may be applied to a display device that displays a display.

For example, when power is not applied to the light route control member as shown in FIG. 19, the receiving unit functions as the light blocking part, so that the display device is driven in a light blocking mode, and when power is applied to the light route control member as shown in FIG. 20, the receiving unit functions as the light transmitting part, so that the display device may be driven in an open mode.

Accordingly, a user may easily drive the display device in a privacy mode or a normal mode according to application of power.

In addition, although not shown in the drawings, the display device to which the light route control member according to the embodiment is applied may also be applied inside the vehicle.

For example, the display device including the light route control member according to the embodiment may display a video confirming information of the vehicle and a movement route of the vehicle. The display device may be disposed between a driver seat and a passenger seat of the vehicle.

In addition, the light route control member according to the embodiment may be applied to a dashboard that displays a speed, an engine, an alarm signal, and the like of the vehicle.

Furthermore, the light route control member according to the embodiment may be applied to a front glass (FG) of the vehicle or right and left window glasses.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

**Claims**

1. A light route control member comprising:

   a first substrate to which light is incident from an external area;
   a first electrode disposed on an upper surface of the first substrate;
   a second substrate disposed above the first substrate;
   a second electrode disposed on a lower surface of the second substrate; and
   a light conversion unit disposed between the first electrode and the second electrode,
   wherein the light conversion unit includes a partition wall unit and a receiving unit alternately disposed,
   the receiving unit changes light transmittance according to application of a voltage,
   a refractive index of the partition wall unit is greater than a refractive index of the external area, and
   a difference between the refractive index of the partition wall unit and the refractive index of the external area is 0.3 or more.

2. The light route control member of claim 1, wherein the difference between the refractive index of the partition wall unit and the refractive index of the external area is 0.3 to 0.9.

3. The light route control member of claim 1, wherein the receiving unit is driven as a light blocking part when the voltage is applied, and
   the receiving unit is driven as a light transmitting part when the voltage is not applied.

4. The light route control member of claim 3,

   wherein light incident on the partition wall unit passes through the receiving unit, and
   the light passing through the receiving unit satisfies the following equation.
   [Equation]

$$\text{Width of receiving unit} * 0.9 < \text{Distance of light passing through receiving unit} < \text{Width of receiving unit} * 1.7.$$

5. The light route control member of claim 3, wherein when the voltage is not applied, transmittance of light incident on the partition wall unit and emitted toward the second electrode is less than 1%.

6. The light route control member of claim 1, wherein the receiving unit includes:

   an electrolyte; and
   a plurality of light absorbing particles dispersed in the electrolyte.

7. The light route control member of claim 6, wherein when the voltage is applied to the receiving unit, the light absorbing particles move in a direction of the first electrode or the second electrode within the receiving unit.

8. The light route control member of claim 1, wherein at least one of one end and the other end of the receiving unit is disposed to be spaced apart from the first electrode and the second electrode.

9. The light route control member of claim 1, further comprising an adhesive layer disposed between the light conversion unit and the second electrode.

10. A display device comprising:

   a display panel; and
   a_light route control member disposed on the display panel,
   wherein the light route control member includes:

      a first substrate to which light is incident from an external area;
      a first electrode disposed on an upper surface of the first substrate;
      a second substrate disposed above the first substrate;
      a second electrode disposed on a lower surface of the second substrate; and
      a light conversion unit disposed between the first electrode and the second electrode,
      wherein the light conversion unit includes a partition wall unit and a receiving unit alternately disposed,
      the receiving unit changes light transmittance according to application of a voltage,
      a refractive index of the partition wall unit is greater than a refractive index of the external area, and
      a difference between the refractive index of the partition wall unit and the refractive index of the external area is 0.3 or more.

【Fig. 1】

1000

120
220
300
210
110

【Fig. 2】

210
110

【Fig. 3】

【Fig. 4】

【Fig. 5】

【Fig. 6】

【Fig. 7】

【Fig. 8】

【Fig. 9】

EXAMPLE

COMPARATIVE EXAMPLE

【Fig. 10】

【Fig. 11】

320

310

210

110

【Fig. 12】

220

120

【Fig. 13】

400

220

120

【Fig. 14】

【Fig. 15】

【Fig. 16】

【Fig. 17】

【Fig. 18】

VIEWING DIRECTION

【Fig. 19】

LIGHT BLOCKING MODE

【Fig. 20】

OPEN MODE

OPEN

## INTERNATIONAL SEARCH REPORT

| | International application No. |
|---|---|
| | **PCT/KR2020/009903** |

**A. CLASSIFICATION OF SUBJECT MATTER**

**G02B 26/08**(2006.01)i; **G02F 1/167**(2006.01)i; **G02F 1/1675**(2019.01)i; **G02F 1/1335**(2006.01)i; **H01L 51/52**(2006.01)i

According to International Patent Classification (IPC) or to both national classification and IPC

**B. FIELDS SEARCHED**

Minimum documentation searched (classification system followed by classification symbols)

G02B 26/08; B82Y 40/00; G02B 006/35; G02B 1/10; G02B 6/00; G02F 001/01; G02F 1/1335; G09F 9/00; H01J 11/36; H01J 9/24; G02F 1/167; G02F 1/1675; H01L 51/52

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 광(light), 투과율(transmittivity), 격벽(barrier), 굴절(refraction), 거리(distance)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2015-0125051 A (LG HAUSYS, LTD.) 09 November 2015. See paragraphs [0036]-[0060], [0081] and [0103]-[0105]; claims 1 and 4; and figures 2-4. | 1-10 |
| Y | KR 10-2014-0033399 A (3M INNOVATIVE PROPERTIES COMPANY) 18 March 2014. See paragraphs [0019]-[0022]; and figures 1b-1c. | 1-10 |
| Y | KR 10-2002-0091754 A (FUJITSU HITACHI PLASMA DISPLAY LIMITED) 06 December 2002. See pages 3 and 5; and figure 1. | 4 |
| A | KR 10-0673041 B1 (SEKONIX CO., LTD.) 22 January 2007. See paragraphs [0044]-[0058] and [0071]-[0084]; claims 1-7; and figures 2-3 and 5-8. | 1-10 |

☑ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 November 2020** | **06 November 2020** |

| Name and mailing address of the ISA/KR | Authorized officer |
|---|---|
| **Korean Intellectual Property Office**<br>**Government Complex Daejeon Building 4, 189, Cheongsa-ro, Seo-gu, Daejeon, Republic of Korea**<br>**35208** | |
| Facsimile No. **+82-42-481-8578** | Telephone No. |

Form PCT/ISA/210 (second sheet) (July 2019)

**INTERNATIONAL SEARCH REPORT**

International application No.

**PCT/KR2020/009903**

### C. DOCUMENTS CONSIDERED TO BE RELEVANT

| Category* | Citation of document, with indication, where appropriate, of the relevant passages | Relevant to claim No. |
|---|---|---|
| A | US 2003-0016905 A1 (KONDOH, Hitoshi et al.) 23 January 2003. See paragraphs [0077]-[0091]; claims 1-11; and figures 1A-4B. | 1-10 |

**INTERNATIONAL SEARCH REPORT**
Information on patent family members

International application No.

**PCT/KR2020/009903**

| Patent document cited in search report | | | Publication date (day/month/year) | Patent family member(s) | | | Publication date (day/month/year) |
|---|---|---|---|---|---|---|---|
| KR | 10-2015-0125051 | A | 09 November 2015 | KR | 10-1756506 | B1 | 11 July 2017 |
| KR | 10-2014-0033399 | A | 18 March 2014 | CN | 103502855 | B | 28 December 2016 |
| | | | | CN | 103502855 | A | 08 January 2014 |
| | | | | EP | 2707765 | A1 | 19 March 2014 |
| | | | | KR | 10-1888222 | B1 | 13 August 2018 |
| | | | | TW | I541559 | B | 11 July 2016 |
| | | | | TW | 201300875 | A | 01 January 2013 |
| | | | | US | 10295724 | B2 | 21 May 2019 |
| | | | | US | 2017-0031078 | A1 | 02 February 2017 |
| | | | | US | 9541701 | B2 | 10 January 2017 |
| | | | | US | 2014-0071653 | A1 | 13 March 2014 |
| | | | | WO | 2012-158414 | A1 | 22 November 2012 |
| KR | 10-2002-0091754 | A | 06 December 2002 | EP | 1263015 | A2 | 04 December 2002 |
| | | | | EP | 1263015 | A3 | 25 February 2004 |
| | | | | JP | 4641361 | B2 | 02 March 2011 |
| | | | | JP | 2002-358896 | A | 13 December 2002 |
| | | | | TW | I244666 | B | 01 December 2005 |
| | | | | US | 6919670 | B2 | 19 July 2005 |
| | | | | US | 2002-0190650 | A1 | 19 December 2002 |
| KR | 10-0673041 | B1 | 22 January 2007 | None | | | |
| US | 2003-0016905 | A1 | 23 January 2003 | JP | 4728515 | B2 | 20 July 2011 |
| | | | | JP | 2002-350795 | A | 04 December 2002 |
| | | | | US | 6707514 | B2 | 16 March 2004 |

Form PCT/ISA/210 (patent family annex) (July 2019)